(19) Europäisches Patentamt / European Patent Office / Office européen des brevets

(11) **EP 3 006 601 B1**

(12) **EUROPEAN PATENT SPECIFICATION**

(45) Date of publication and mention
of the grant of the patent:
**11.12.2019 Bulletin 2019/50**

(21) Application number: **14803693.2**

(22) Date of filing: **27.05.2014**

(51) Int Cl.:
*C22C 38/02* (2006.01)  *C23C 8/80* (2006.01)
*C23C 28/04* (2006.01)  *C23C 8/36* (2006.01)
*C21D 1/06* (2006.01)  *C21D 1/18* (2006.01)
*C23C 14/06* (2006.01)  *C22C 38/00* (2006.01)
*C22C 38/60* (2006.01)  *C22C 38/04* (2006.01)
*C22C 38/06* (2006.01)  *C22C 38/34* (2006.01)
*C22C 38/42* (2006.01)  *C22C 38/44* (2006.01)
*C22C 38/46* (2006.01)

(86) International application number:
**PCT/JP2014/063937**

(87) International publication number:
**WO 2014/192730 (04.12.2014 Gazette 2014/49)**

(54) **METHOD FOR MANUFACTURING MOLD FOR COLD WORKING USE**

VERFAHREN ZUR HERSTELLUNG EINER FORM ZUR VERWENDUNG FÜR KALTBEARBEITUNG

PROCÉDÉ DE FABRICATION D'UN MOULE POUR UNE UTILISATION EN FORMAGE À FROID

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.05.2013 JP 2013113953**

(43) Date of publication of application:
**13.04.2016 Bulletin 2016/15**

(73) Proprietor: **Hitachi Metals, Ltd.**
**Tokyo 108-8224 (JP)**

(72) Inventors:
• **SHOUJI Tatsuya**
 **Yasugi-shi**
 **Shimane**
 **6928601 (JP)**
• **HONDA Fumiaki**
 **Yasugi-shi**
 **Shimane 692-8601 (JP)**
• **MORISHITA Kana**
 **Yasugi-shi**
 **Shimane 692-8601 (JP)**

(74) Representative: **Beetz & Partner mbB**
**Patentanwälte**
**Robert-Koch-Str. 1**
**80538 München (DE)**

(56) References cited:
WO-A1-99/50469    WO-A1-2012/115024
WO-A1-2012/115024   JP-A- S5 831 066
JP-A- 2000 271 699  JP-A- 2008 189 982
JP-A- 2009 299 142  JP-A- 2012 001 744
JP-A- 2012 107 265  US-A1- 2002 160 235
US-A1- 2003 059 632  US-A1- 2006 157 163

**Description**

TECHNICAL FIELD

The present invention relates to a method for manufacturing a cold working die having a hard coating film.

BACKGROUND ART

In recent years, various surface treatments of a working surface of a cold working die used for press forming such as bending, drawing or punching of a sheet material at a room temperatures have been widely implemented to improve wear resistance or galling resistance. In particular, since coating processes can deposit a hard coating film having a Vickers hardness (HV) of more than 1000, a lifetime of the die having the hard coating film is greatly increased. Among the coating processes for applying the hard coating film, a physical vapor deposition process (hereinafter, also referred to as "PVD process") can typically deposit the coating film at a temperatures lower than a tempering temperature of a steel, and thus the steel is less softened during the process. Thus, deformation or dimensional change is hardly caused.

For a cold working die used for press forming, a conventional steel material is employed, which is provided in an annealed state where a harness thereof is low, then roughly processed, and then quenched and tempered to have a hardness to be used (see Patent Literatures 1 and 2). However, since the quenching and tempering cause heat treatment deformation, fine machining process is again necessary, after the adjustment to the hardness to be used, to correct the deformation and adjust the die into a final shape, thereby increasing manufacturing steps.

On the other hand, a prehardened steel also has been proposed which is provided after adjusted to a hardness to be used in advance (see Patent Literatures 3 and 4). The final re-machining process as described above can be omitted and the problem of dimensional change is eliminated by employing the prehardened steel.

Patent Literature 5 provides a tool for aluminum cans, the tool material including: a base material made of a tool steel; a nitrided layer on the surface of the base material; a hard coating film on the nitrided layer, the hard coating film being composed of a single body or a mixture of nitrides, carbides or carbonitrides and a coating film of Al-Cr based nitride on the hard coating film.

Patent Literature 6 relates to a coated tool comprising a base material and a coating as a working surface, the coating having a layer 'a' made of at least one kind selected from the group consisting of a nitride, a carbide and a carbonitride, each of which containing as the main constituent thereof at least on metal element selected from the group consisting of Ti, V, Cr, Al and Si; and a layer 'b' provided on the layer 'a', the layer 'b' being made of a sulfide.

Patent Literature 7 describes a punch for cold working, having a nitride coat layer on the surface of the body of a punch of a high alloy steel having a specified composition by nitriding at a low temperature and by coating the nitrided coat layer with a hardened layer by vapor deposition.

Patent Literature 8 describes a cold working steel having the following chemical composition in weight%: 0.82-0.97C, from traces to max. 1.10 Si, from traces to max. 0.62 Mn, at least 7.6 but less than 8.0 Cr, 2.30-2.70 Mo, 0.35-0.55 V, balance iron and impurities in normal amounts in the form of residual elements from the manufacture of the steel.

CITATION LIST

PATENT LITERATURE

PATENT LITERATURE 1: JP-A-2009-132990
PATENT LITERATURE 2: JP-A-2006-193790
PATENT LITERATURE 3: JP-A-2008-189982
PATENT LITERATURE 4: WO 2012/115024
PATENT LITERATURE 5: JP 2012-107265
PATENT LITERATURE 6: US 2003/0059632 A1
PATENT LITERATURE 7: JP 58031066
PATENT LITERATURE 8: WO99/50469

## SUMMARY OF INVENTION

### TECHNICAL PROBLEM

As the prehardened steel has a higher hardness, satisfactory machinability can not be obtained. In contrast, as the hardness becomes lower, the machinability is improved. However, it is confirmed that a hard coating film deposited by a PVD process has lower adhesion.

The present invention has been made in view of the above circumstances. The present invention provides a method for manufacturing a cold working die with a prehardened steel having an available hardness for the cold working die at minimum while exhibits excellent adhesion of the hard coating film.

### SOLUTION TO PROBLEM

The above object is achieved by the invention as defined in the independent claim. Advantages embodiments of the present invention are the subject of dependent claims.

The present invention provides a method for manufacturing a cold working die, including steps of:

quenching and tempering a steel material including, by mass, 0.6% to 1.2% of carbon, 3.0% to 9.0% of chromium, 0.01% to less than 0.3% of aluminum, 0.3% to 2.0% of manganese, 0.02% to 0.1% of sulfur, optionally one or both of niobium and vanadium in an amount of (Nb + 1/2V) being not more than 1.0%, optionally one or more of silicon, nickel, tungsten, molybdenum, and copper, and the balance being iron and inevitable impurities, to provide a prehardened steel having a hardness of not lower than 55 HRC;

machining the prepared prehardened steel to form a working surface of the cold working die;

nitriding the machined working surface to produce a nitrided layer having a thickness of not more than 80 $\mu$m; and

depositing a hard coating film onto the nitrided working surface through a physical vapor deposition process.

The nitrided layer formed by the nitriding treatment preferably has a thickness of not less than 40 $\mu$m. Further preferably, the steel material includes, by mass, 0.04% to 0.15% of aluminum.

The hard coating film preferably includes nitrides. The nitrides preferably include aluminum and chromium.

### ADVANTAGEOUS EFFECTS OF INVENTION

According to the present invention, a cold working die having a hardness of not lower than 55 HRC which is an available hardness for the cold working die and having excellent adhesion of a hard coating film can be manufactured from a prehardened steel. The prehardened steel can omit a step of quenching and tempering the cold working die which had been machined to form a working surface. In addition, since a hard coating film is deposited by a physical vapor deposition process, deformation and dimensional change of the cold working die during the coating process can be prevented. Therefore, the method can manufacture the cold working die having excellent mechanical properties with improved comprehensive manufacturing efficiency.

### DESCRIPTION OF EMBODIMENTS

The present inventors studied to manufacture a cold working die with a prehardened steel. Then, it has been found that it is effective to nitride the steel before applying the hard coating film while adjusting carbon and chromium contents of the steel material in order to provide the die having minimum available hardness for the die and having high adhesion of the hard coating film, thereby achieving the manufacturing method of the present invention. The invention will be described below in detail.

In the present invention, a cold working die is manufactured with a prehardened steel having a hardness of not lower than 55 HRC in order to give wear resistance minimum required for the cold working die. When the hardness is lower than 55 HRC, the wear resistance is reduced and it is difficult to be used for the cold working die. On the other hand, when the hardness of the prehardened steel is excessively high, it is difficult to be machined and satisfactory machinability can not be obtained, depending on a composition of the steel. As a result, the hardness is preferably not greater than 62 HRC for ensuring excellent machinability, more preferably not greater than 60 HRC, and further preferably less than 60 HRC.

The term "machining" referred to herein includes: processing using a typical cutting tool such as a drill, a tap, an insert or an end mill to produce a working surface of a cold working die; grinding the working surface with e.g., an abrasive; or the like.

The "HRC" represents Rockwell Hardness HR, which is a scale showing an indentation hardness, and which is obtained by following equation under conditions of
indenting tool: 120° conical diamond and
test force: 150 kgf in accordance with JIS B7726:

$$HR = 100 - 500\ h$$

(h: an actual indentation depth [mm] when an indentation depth at a preliminary test force (10 kgf) is 0)

In operating the cold working die, some parts are subjected to local high contact pressure due to e.g. wear debris or wrinkling of the work generated during the formation. When the contact pressure is particularly high, the base material can not bear the pressure and is easily subjected to plastic deformation. If the steel material has a low hardness when applying a hard coating film such as a ceramic having a high hardness, to a surface of the cold working die, the hard coating film can not conform to the plastic deformation of the base material, resulting in a crack generated inside the hard coating film to easily cause exfoliation.

The present inventors considered nitriding the steel before the application of the hard coating film in order to achieve high adhesion of the hard coating film even the cold working die has a minimum available hardness for the cold working die. If nitrogen penetrates at a depth of tens of microns into the steel from its surface to harden the steel surface by the nitriding treatment, the steel is hardly deformed plastically even by a high contact pressure, thereby enhancing adhesion of the hard coating film. Furthermore, the nitriding treatment imparts compressive stress to the steel surface to relieve extreme stress difference at the interface between the base material and the hard coating film. As a result, the nitriding treatment tends to improve the adhesion of the hard coating film applied through a PVD process which imparts high residual compressive stress.

Then, the present inventors found out that it is important to limit the chromium content of the steel material to a certain amount or lower in order to enhance the adhesion of the hard coating film by the nitriding treatment. However, if the chromium content is excessively decreased, an amount of $M_7C_3$ carbides formed in the structure after quenching and tempering is decreased, and thus the hardness and also the wear resistance of the cold working die are reduced. Then, the present inventors studied amounts of carbon and chromium in the steel material in order to use solid solute carbon to compensate for the reduction of hardness of the steel material by limiting the chromium content. Carbon is an important element for forming a carbide in the steel while imparting hardness to the cold working die. An excessively low carbon content leads to lack of an amount of solid solution to reduce a wear resistance of the cold working die. On the other hand, an excessively high carbon content leads to increased carbides, making it difficult to be machined after quenching and tempering.

In the present invention, a prehardened steel including, 0.6% to 1.2% of carbon and 3.0% to 9.0% of chromium, by mass, (hereinafter, expressed simply as %) in order to achieve the above effects. Preferably, the carbon content is not lower than 0.7% in order to enhance the wear resistance of the cold working die. Further preferably, the chromium content is not lower than 4.0%.

In order to further improve the machinability of the prehardened steel, the carbon content is preferably not more than 1.0%, and further preferably not more than 0.9%.

In order to enhance the adhesion of the hard coating film by the nitriding treatment, the chromium content is preferably not more than 8.0%.

The nitrided layer having a thickness of not less than 20 μm is preferable for enhancing the adhesion. The thickness is further preferably not less than 30 μm, and further more preferably not less than 40 μm. The nitrided layer is to have a thickness of not greater than 80 μm since a thick nitrided layer increases a risk of generation of a crack in the die. Further preferably, the thickness is not greater than 70 μm.

Conventional methods such as gas nitriding and plasma nitriding can be selectively employed for the nitriding treatment. A machined cold working die may be softened if a temperature of the nitriding step is excessively high. Accordingly, the nitriding treatment is preferably conducted at not higher than 600°C, and further preferably not higher than 550°C. If the temperature of the nitriding step is excessively low, the nitrided layer is hardly formed. Accordingly, the nitriding treatment is preferably conducted at not lower than 400°C.

In some cases, a nitride layer, that is called as a white layer, may be formed depending on nitriding conditions. The white layer may cause reduction of adhesion of the hard coating film, and thus the formation of the white layer is preferably prevented by controlling the nitriding treatment or removing the white layer by e.g., grinding.

Preferably, the working surface of the cold working die before the nitriding treatment has a surface roughness of not greater than 0.1 μm Ra and not greater than 1.0 μm Rz, when the roughness is measured as an arithmetic mean roughness Ra (pursuant to JIS-B-0601-2001) and as a maximum height roughness Rz (pursuant to JIS-B-0601-2001). The adhesion of the hard coating film is improved as the working surface is made smoother. The surface roughness is more preferably not greater than 0.08 μm Ra and not greater than 0.8 μm Rz, and further preferably not greater than

0.04 $\mu$m Ra and not greater than 0.2 $\mu$m Rz.

The steel material according to the present invention can be provided by conventional methods or the like. For example, the steel material may be provided by producing a steel ingot through an ordinary ingot-casting using an ingot mold as well as a continuous casting, or a vacuum arc remelting process or an electroslag remelting process performed on a casted steel ingot, or the like. Then, the ingot is subjected to hot working such as blooming and forging to shape the ingot into a steel piece such as a slab, a bloom, or a billet by.

In the PVD process employed in the present invention, the steel is generally treated at a lower temperature than a quenching and tempering temperature. Thus, the cold working die is less likely to be subjected to dimensional change due to heat treatment through the coating process as compared to a chemical vapor deposition process or a TD process which are high-temperature processing. As the PVD process, can be employed a sputtering process using a sputtering phenomenon where a target is bombarded by an ion to eject a target atom, an arc ion plating process for evaporate a target surface using an arc discharge, or the like. Among the PVD processes, the hard coating film is preferably applied by the arc ion plating process since excellent adhesion of the hard coating film can be obtained. After depositing the hard coating film with the arc ion plating process, a surface of the hard coating film is preferably grinded for removing droplets therefrom.

In order to impart high wear resistance to the cold working die, a hard coating film preferably has a Vickers hardness (HV 0.025) of not lower than 2000 HV. A hard coating film made of nitrides tends to have an excellent heat resistance and thus is particularly preferable for improving durability of the cold working die. Among nitride hard coating films, preferably is a nitride hard coating film which metal (including semimetal) part includes aluminum and chromium since it has excellent wear and heat resistance. In particular, a nitride hard coating film having a total amount of aluminum and chromium being not less than 90 atomic % in relation to the metal (including semimetal) part is preferably.

The hard coating film may be composed of a single layer or of a multi layers. A total thickness of the hard coating film is preferably not less than 3 $\mu$m and more preferably not less than 4 $\mu$m to improve the durability of the cold working die.

In the process of depositing the hard coating film, a negative bias voltage to be applied to the base material is preferably -220 V to -70 V. If the negative bias voltage is higher than -70 V, the hard coating film will be insufficient dense, thereby possibly reducing the adhesion. If the negative bias voltage is lower than -220 V, stable film deposition will be difficult. Furthermore, the negative bias voltage is preferably -200 V to -90 V.

The steel material of the present invention may include silicon, manganese, molybdenum, tungsten, or the like. Manganese dissolves in the steel to effectively impart hardenability. Silicon dissolves in the steel and is effectively for increasing hardness. Molybdenum and tungsten form fine carbides and are effective for increasing hardness by tempering. Furthermore, nickel, copper may be added to the steel material. Aluminum and sulfur contribute to improving machinability of the prehardened steel. Aluminum, nickel and copper contribute to improving hardness and toughness of the cold working die.

Since vanadium and niobium form an MC carbide, which is a primary carbide, in a structure after quenching and tempering, they are effective for achieving a hardness of not lower than 55 HRC. However, the MC carbides are very hard. Accordingly, when vanadium and niobium are included excessively, a large amount of MC carbides is formed and reduces machinability of the prehardened steel. While vanadium and niobium have similar effects in these respects, niobium has about twice effect of the same amount of vanadium. Therefore, these contents can be treated in combination as a relationship (Nb + 1/2V). Thus, when one or two kinds of vanadium and niobium are included the amount is not more than 1.0 mass% in the expression (Nb + 1/2V), more preferably not more than 0.8 mass%.

Then, it is preferable according to the present invention to employ a steel material which composition is adjusted so as to sufficiently form a complex lubricating protective film composed of $Al_2O_3$ which is an oxide having a high melting point, and MnS which is a high ductility inclusion, on a surface of a cutting tool due to heat generated in a cutting process for further improving the machinability of the prehardened steel. The complex lubricating protective film exhibits stable effects in a wide range of cutting temperatures and also ensures favorable machinability even when elements, such as niobium and vanadium, forming hard MC carbides are added in the steel material. In order to form a sufficient complex lubricating protective film at the cutting edge of the tool to more improve the machinability, the steel material according to the present invention includes, by mass, not less than 0.01% and less than 0.3% of aluminum, 0.3% to 2.0% of manganese, and 0.02% to 0.1% of sulfur.

Aluminum forms $Al_2O_3$ which is the high melting point oxide, on a surface of the cutting tool during a cutting process, and $Al_2O_3$ functions as a protective film. The steel includes not less than 0.01% aluminum, since aluminum then forms the protective film with a sufficient thickness, thereby improving a tool life. It is more preferable that not less than 0.04% of aluminum is included. Further preferably aluminum is included by not less than 0.05%. However, when aluminum is added excessively, aluminum forms a large amount of $Al_2O_3$ in the steel material as inclusions, which contrarily reduces the machinability of the steel material. Therefore, the aluminum content is less than about 0.3% and more preferably not more than 0.15%.

Manganese functions as a favorable lubricating film on the $Al_2O_3$ protective film formed on the cutting tool surface. Manganese is an austenite-forming element and dissolves in the steel to improve hardenability. However, when manganese is added excessively, the steel includes a large amount of retained austenite after quenching and tempering, which will cause dimensional change of the tool as it is used over time. In addition, since manganese readily forms an oxide with iron or chromium and the oxide has a low melting point, manganese becomes a cause of inhibiting the function of the $Al_2O_3$ protective film. Accordingly, the steel includes not less than 0.3% but not more than 2.0% of manganese. More preferably, not less than 0.4%, and more preferably not more than 1.5%.

Sulfur functions as a favorable lubricating film on the $Al_2O_3$ protective film formed on the cutting tool surface. Sulfur is included in an amount of not less than 0.02% for fully exhibiting such a lubricating function. However, since sulfur degrades a toughness of the steel, an upper limit of the sulfur content is 0.1%. More preferably, sulfur is included in not less than 0.03%, and more preferably not more than 0.08%.

EXAMPLE 1

Steel ingots Nos. 1 to 4 having compositions in Table 1 were prepared, out of these specimens 1 and 4 fulfill the requirements of claim 1. These ingots were subjected to hot forging at a forging ratio of about 10. Then, they were cooled and annealed at 860°C. Then, these annealed materials were quenched by air cooling. The steel ingots Nos. 1, 3 and 4 were quenched from 1030°C and the steel ingot No. 2 was quenched from 960°C. After quenched, the steel ingots were tempered twice at 500 to 540°C so that each ingot was adjusted to have two levels of hardness, 60 HRC and 56 HRC.

Here, the steel ingot No. 1 in Table 1 corresponds to the prehardened steel disclosed in Patent Literature 4. The steel ingot No. 2 corresponds to SKD12 specified in JIS-G-4404 (alloy tool steels), and the steel ingot No. 3 corresponds to SKD11.

[TABLE 1]

| Ingot No. | Composition (mass%) | | | | | | | | | | | | | |
|---|---|---|---|---|---|---|---|---|---|---|---|---|---|---|
| | C | Si | Mn | P | S | Ni | Cr | W | Mo | V | Cu | Al | Nb | Fe |
| 1 | 0.81 | 1.44 | 0.80 | 0.027 | 0.0540 | 0.06 | 4.93 | 0.01 | 1.03 | 0.27 | 0.03 | 0.069 | <0.01 | Bal. |
| 2 | 1.00 | 0.30 | 0.60 | 0.030 | 0.0100 | 0.10 | 5.30 | <0.01 | 1.10 | 0.20 | <0.01 | 0.020 | <0.01 | Bal. |
| 3 | 1.35 | 0.29 | 0.39 | 0.025 | 0.0005 | 0.11 | 11.96 | 0.04 | 0.84 | 0.25 | 0.03 | 0.018 | <0.01 | Bal. |
| 4 | 0.70 | 1.97 | 1.00 | 0.016 | 0.0550 | 0.02 | 7.23 | <0.01 | 1.51 | 0.01 | 0.01 | 0.018 | <0.01 | Bal. |

In order to evaluate machinability of the steel ingots for forming a working surface, each of the above prehardened steel was subjected to a cutting test under following machining conditions and tool life thereof was measured.

<Cutting test>

Tool: High feed radius mill
φ32 * 5 blades (manufactured by Hitachi Tool Engineering, Ltd.)
Cutter Model: ASRS2032R-5
Insert Model: EPMT0603TN-8
Cutting Method: Bottom surface cutting
Cutting Depth: 0.5 mm in axial direction and 15 mm in radial direction
Number of Blade: 1
Cutting Speed: 120 mm/min
Table Feed rate: 367 mm/min
Coolant: Air-blow
Time until a wear width of a flank reaches 0.2 mm was defined as a tool life. (The larger the value is, the more excellent the machinability is). The results are shown in Table 2.

[TABLE 2]

| Ingot No. | Hardness (HRC) | Tool life (minute) |
|---|---|---|
| 1 | 56 | 80 |
| | 60 | 50 |

(continued)

| Ingot No. | Hardness (HRC) | Tool life (minute) |
|---|---|---|
| 2 | 56 | 20 |
| | 60 | 5 |
| 3 | 56 | Test stopped |
| | 60 | Test stopped |
| 4 | 56 | 40 |
| | 60 | 15 |

In the steel ingot No. 1, a carbon content is adjusted for decreasing an amount of carbides in the steel. In a case where the hardness is 56 HRC, it reached the tool life for about 80 minutes. Furthermore, the steel ingot No. 1 is adjusted to have a particularly preferable composition for forming a complex lubricating protective film on a cutting edge of the tool during machining. Therefore, even in a case where the hardness is 60 HRC, the tool life reached as long as about 50 minutes since tool damage was suppressed. This shows that the steel ingot No.1 is suitable for machining of the working surface of the cold working die as a prehardened steel having a hardness of not lower than 55 HRC.

In the steel ingot No. 2, a carbon content is also adjusted for decreasing an amount of carbides in the steel. In a case where the hardness is 56 HRC, the tool life reached about 20 minutes. In a case where the hardness is 60 HRC, the tool life was about 5 minutes. This shows that the steel ingot No.2 is suitable for machining of the working surface of the cold working die when used as a prehardened steel having a hardness in the range of not lower than 55 HRC but less than 60 HRC.

Since the steel ingot No. 3 has a high carbon content, it includes a large amount of carbides in the steel. In both cases where the hardness is 56 HRC and 60 HRC, a damage of the tool occurred at an early stage before the width of tool flank wear reached 0.2 mm and the cutting test was stopped. This shows that the steel ingot No. 3 was not suitable for machining the working surface of the cold working die as a prehardened steel.

Also in the steel ingot No. 4, a carbon content is adjusted for reducing an amount of carbides in the steel. In a case where the hardness is 56 HRC, the tool life reached about 40 minutes. Since the composition of the steel ingot No. 4 is adjusted for forming a complex lubricating protective film on a cutting edge of the tool during machining, the tool does not damaged at an early stage and the tool life reached about 15 minutes even in a case where the hardness is 60 HRC. This shows that the steel ingot No. 4 was suitable for machining of the working surface of the cold working die as a prehardened steel.

As described above, the steel ingots Nos. 1 and 4 have adjusted carbon contents for decreasing the amount of carbides in the steel and further adjusted composition for facilitating formation of a complex lubricating protective film on the cutting edge of the tool during machining. They exhibited excellent machinability even in a case of the high hardness of 60 HRC. When such a steel ingot is used as a prehardened steel, sufficient machinability can be ensured without decreasing a hardness to around 55 HRC, which hardness is minimum required for a cold working die. In particular, it was observed that the steel ingot No. 1, which has adjusted aluminum content for forming the sufficient complex lubricating protective film, exhibited extremely excellent machinability even in the case of 60 HRC.

Even for the steel ingot No. 2 which has adjusted carbon content for decreasing an amount of carbides while having a composition not forming the complex lubricating protective film, excellent machinability can be sufficiently ensured by reducing a hardness to around 55 HRC which is a hardness minimum required for the cold working die or by easing machining conditions.

On the other hand, the steel ingot No. 3 having a high carbon content and including a large amount of carbides in the steel exhibited extremely poor machinability even when a hardness is reduced to around 55 HRC. Therefore, a steel material having a high carbon content like the steel ingot No. 3 has extremely deteriorated machinability, and it is difficult to manufacture the cold working die.

EXAMPLE 2

The foregoing prehardened steels were processed to prepare specimens of 20 mm * 20 mm * 5 mm. Assuming surfaces of the specimens as a working surface of the cold working die, a hard coating film was applied to each working surface. Then, adhesion of the hard coating film was evaluated.

First, a flat surface of each specimen (specimens Nos. 1 to 12, a relation of each specimen with steel ingot No. and hardness of the steel are shown in Table 4) was ground to have a surface roughness of not more than 0.01 μm when measured as an arithmetic mean roughness Ra (pursuant to JIS-B-0601-2001), and not more than 0.05 μm when

measured as a maximum height roughness Rz (pursuant to JIS-B-0601-2001), and then was subjected to alkali cleaning.

Next, nitriding treatment was conducted with use of a plasma nitriding furnace having an internal dimensions of $\phi$700 mm * 1200 mm (effective internal dimensions of $\phi$600 mm * 600 mm) for specimens to be nitrided (specimens Nos. 1 to 7 and 10). Before the nitriding treatment, an inside of the furnace was heated to 410°C under vacuum, and the surfaces of the specimens were subjected to gas etching at a gas ratio of $N_2$:$H_2$:Ar = 6:91:3. After that, the specimens were nitrided under following conditions. Nitriding conditions "A" includes a treatment temperature of 450°C, a treatment time of 20 min, and a gas ratio of $N_2$:$H_2$ = 50:50. Nitriding conditions B included a treatment temperature of 490°C, a treatment time of 120 min, and a gas ratio of $N_2$:$H_2$ = 1:99.

The specimens Nos. 8, 9, 11 and 12 were not nitrided and a hard coating film was directly applied thereto by an arc ion plating process that will be described later.

An arc ion plating device having a chamber volume of 1.4 $m^3$ (a space for insertion of article to be treated is 0.3 $m^3$) was used for depositing the hard coating film. After each specimen was placed in the furnace, the furnace was degassed by heating at a temperature of 773 K in a vacuum of $1 \times 10^{-3}$ Pa. After that, each specimen was subjected Ar plasma cleaning at a temperature of 723 K. Then, a reactant gas was introduced into the device, and an arc discharge is generated on the target. Thus, a coating film was deposited at 723 K.

An AlCrN film was formed on all the specimens when an $Al_{60}Cr_{40}$ target (the numbers indicate an atomic ratio) was used on conditions of a making current of 150 A applied to the target, a reactant gas pressure of 3 Pa, a table rotation speed of 3 rpm, a reactant gas of $N_2$ and a bias voltage of -100 V applied to the base material during the formation of the film. A film-formation time was adjusted so that the film thickness becomes 4 $\mu$m. A Vickers hardness (HV0.025) of the hard coating film was 3000 HV when measured from a surface of the film.

In order to measure a depth of the nitrided layer, each specimen was cut and the Vickers hardness (HV0.05) from its surface was measured in accordance with the procedure defined in JIS-G-0562 (Method of measuring nitrided case depth for iron and steel). A hardness of each specimen at 0.2 mm depth from the surface was defined as an inner hardness and a depth from the surface at which the Vickers hardness was higher than the inner hardness by 50 HV or more was defined as a depth of the nitrided layer. The measurement results of the Vickers hardness of each specimen are shown in Table 3. The specimens Nos. 2, 4, 5, 6 and 7 had a Vickers hardness HV of not lower than 900 HV at 0.010 mm depth from the surface. The hardness at 0.010 mm depth from the surface was 200 HV or more higher than the inner hardness. The specimens Nos. 2, 4, 6 and 7 had a Vickers hardness HV of not lower than 900 HV at 0.020 mm depth from the surface. The depth of the nitrided layer of each specimen obtained from the Vickers hardness in Table 3 is shown in Table 4.

[TABLE 3]

| Depth from surface /mm | Cross sectional Vickers hardness / $HV_{0,05}$ | | | | | | | | | | | |
|---|---|---|---|---|---|---|---|---|---|---|---|---|
| | Specimen No.1 | Specimen No.2 | Specimen No.3 | Specimen No.4 | Specimen No.5 | Specimen No.6 | Specimen No.7 | Specimen No.8 | Specimen No.9 | Specimen No.10 | Specimen No.11 | Specimen No.12 |
| 0.010 | 761 | 992 | 835 | 989 | 968 | 997 | 1104 | 673 | 646 | 765 | 672 | 697 |
| 0.015 | 755 | 987 | 803 | 971 | 913 | 983 | 1043 | - | - | 680 | - | - |
| 0.020 | 705 | 964 | 779 | 965 | 816 | 933 | 951 | - | - | 636 | - | - |
| 0.025 | 697 | 921 | 775 | 933 | 777 | 911 | 888 | - | - | 626 | - | - |
| 0.030 | 676 | 861 | 723 | 922 | 740 | 891 | 863 | - | - | 629 | - | - |
| 0.035 | 667 | 786 | 713 | 852 | 703 | 834 | 833 | - | - | - | - | - |
| 0.040 | 654 | 756 | 679 | 789 | 695 | 796 | 814 | - | - | - | - | - |
| 0.045 | 648 | 751 | 659 | 774 | 681 | 795 | 758 | - | - | - | - | - |
| 0.050 | 638 | 725 | 647 | 724 | 677 | 792 | 756 | - | - | - | - | - |
| 0.055 | - | 713 | - | 700 | - | 769 | 752 | - | - | - | - | - |
| 0.060 | - | 711 | - | 680 | - | 761 | 746 | - | - | - | - | - |
| 0.065 | - | 691 | - | 672 | - | 732 | 714 | - | - | - | - | - |
| 0.070 | 631 | 684 | 654 | 641 | 679 | 719 | 718 | - | - | - | - | - |
| 0.075 | - | 659 | - | 647 | - | 698 | 719 | - | - | - | - | - |
| 0.080 | - | 675 | - | 633 | - | 691 | 671 | - | - | - | - | - |
| 0.200 | 623 | 670 | 645 | 640 | 676 | 698 | 682 | 669 | 643 | 628 | 671 | 697 |
| Remarks | Examples of present invention | | | | | | | Comparative examples | | | | |
| the sign "-" in the table indicates unmeasured. | | | | | | | | | | | | |

Measurement of adhesion was conducted through a scratch test by a diamond indenter (C scale) with use of a scratch tester (REVETEST manufactured by CSM Instruments SA). The scratch test was carried out under conditions of a load of 0 N to 120 N, a loading speed of 1 N/s, a scratch distance of 12 mm, and a scratch speed of 1 mm/s.

In the scratch test, an initial load at which any breakage was observed in an appearance of a scratch scar was defined as an initial critical load. Also, a load at which the base material was exposed was defined as a critical load. The test results of the adhesion are shown in Table 4.

[TABLE 4]

| Specimen No. | Steel Ingot No. | Nitriding condition | Hardness of base material / HRC | Depth of nitrided layer / μm | Scratch adhesion Critical load | | Remarks |
| --- | --- | --- | --- | --- | --- | --- | --- |
| | | | | | Initial critical load / N | Critical load / N | |
| 1 | 1 | A | 56 | 30 | 42 | 110 | Examples |
| 2 | 1 | B | 56 | 50 | 52 | 117 | |
| 3 | 2 | A | 56 | 35 | 42 | 110 | |
| 4 | 2 | B | 56 | 55 | 56 | No exfoliation | |
| 5 | 1 | A | 60 | 30 | 52 | 117 | |
| 6 | 1 | B | 60 | 60 | 68 | No exfoliation | |
| 7 | 4 | B | 60 | 60 | 72 | No exfoliation | |
| 8 | 1 | - | 56 | - | 35 | 85 | Comparative examples |
| 9 | 2 | - | 56 | - | 35 | 85 | |
| 10 | 3 | A | 56 | 15 | 42 | 92 | |
| 11 | 1 | - | 60 | - | 36 | 97 | |
| 12 | 4 | - | 60 | - | 39 | 83 | |

The specimens Nos. 1 to 4 exhibited excellent adhesion with initial critical loads of not lower than 40 N and critical loads of not lower than 100 N while having a hardness of 56 HRC. Among the examples the specimens Nos. 5 to 7 tended to be very hard and have excellent adhesion.

The specimens Nos. 8 and 9 of comparative examples had an initial critical load and a critical load lower than those of the examples since they were not nitrided, and had reduced adhesion.

The specimen No. 10 of a comparative example did not form a sufficient nitrided layer, although it has been nitrided similarly to the specimens Nos. 1, 3 and 5, since it had a high chromium content in the steel material. Therefore, the specimen No. 10 had a low initial critical load and a low critical load, resulting in reduced adhesion.

The specimens Nos. 11 and 12 of comparative examples had a hardness of 60 HRC. However, they were not nitrided, and thus had initial critical loads and critical loads lower than those of the examples of the present invention, resulting in reduced adhesion.

## Claims

1. A method for manufacturing a cold working die, comprising steps of:

quenching and tempering a steel material including, by mass:

0.6% to 1.2% of carbon,
3.0% to 9.0% of chromium,
0.01% to less than 0.3% of aluminum,

0.3% to 2.0% of manganese,
0.02% to 0.1% of sulfur,
optionally one or both of niobium and vanadium in an amount of (Nb + 1/2V) being not more than 1.0%,
optionally one or more of silicon, nickel, tungsten, molybdenum, and copper, and
the balance being iron and inevitable impurities,

to provide a prehardened steel having a hardness of not lower than 55 HRC;
machining the prehardened steel to form a working surface of the die;
nitriding the machined working surface to produce a nitrided layer having a thickness of not more than 80 $\mu$m; and
depositing a hard coating film onto the nitrided working surface through a physical vapor deposition process.

2. The method according to claim 1, wherein the nitrided layer having a thickness of not less than 40 $\mu$m is formed in the nitriding step.

3. The method according to any one of the preceding claims, wherein the steel material comprises, by mass, 0.04% to 0.15% of aluminum.

4. The method according to any one of the preceding claims, wherein the hard coating film comprises nitrides.

5. The method according to claim 4, wherein the nitrides comprises aluminum and chromium.

**Patentansprüche**

1. Verfahren zur Herstellung einer Kaltarbeitsform, mit den Schritten:
Abschrecken und Anlassen eines Stahlwerkstoffs, der als Gewichtsanteil enthält:

0,6% bis 1,2% Kohlenstoff,
3,0% bis 9,0% Chrom,
0,01% bis weniger als 0,3% Aluminium,
0,3% bis 2,0% Mangan,
0,02% bis 0,1% Schwefel,
optional Niob und/oder Vanadium in einer Menge von (Nb + 1/2V), die nicht mehr als 1,0% beträgt,
optional eines oder mehrere von Silizium, Nickel, Wolfram, Molybdän und Kupfer,
wobei der Rest Eisen und unvermeidliche Verunreinigungen sind,
um einen vorgehärteten Stahl mit einer Härte von nicht weniger als 55 HRC bereitzustellen;
abtragendes Bearbeiten des vorgehärteten Stahls, um eine Arbeitsfläche der Form zu bilden;
Nitrieren der bearbeiteten Arbeitsfläche, um eine nitrierte Schicht mit einer Dicke von nicht mehr als 80 $\mu$m zu bilden; und
Abscheiden eines harten Beschichtungsfilms auf der nitrierten Arbeitsfläche durch einen physikalischen Dampfabscheidungsprozess.

2. Verfahren nach Anspruch 1, bei dem im Schritt des Nitrierens die nitrierte Schicht mit einer Dicke von nicht weniger als 40 $\mu$m gebildet wird.

3. Verfahren nach einem der vorstehenden Ansprüche, bei dem der Stahlwerkstoff 0,04 Gew.-% bis 0,15 Gew.-% Aluminium umfasst.

4. Verfahren nach einem der vorstehenden Ansprüche, bei dem der harte Beschichtungsfilm Nitride umfasst.

5. Verfahren nach Anspruch 4, bei dem die Nitride Aluminium und Chrom umfassen.

**Revendications**

1. Procédé de fabrication d'une matrice pour formage à froid, comprenant les étapes consistant à :
tremper et faire revenir un matériau en acier comprenant, en masse :

0,6 % à 1,2 % de carbone,
3,0 % à 9,0 % de chrome,
0,01 % à moins de 0,3 % d'aluminium,
0,3% à 2,0% de manganèse,
0,02 % à 0,1 % de soufre,
facultativement l'un ou les deux parmi le niobium et le vanadium en une quantité de (Nb + 1/2V) ne dépassant pas 1,0%,
facultativement un ou plusieurs parmi le silicium, le nickel, le tungstène, le molybdène et le cuivre, et
le reste étant du fer et des impuretés inévitables,
pour obtenir un acier pré-durci ayant une dureté non inférieure à 55 HRC ;
usiner l'acier pré-durci pour former une surface de travail de la matrice ;
nitrurer la surface de travail usinée pour obtenir une couche nitrurée d'une épaisseur ne dépassant pas 80 $\mu$m ; et
déposer un film de revêtement dur sur la surface de travail nitrurée par un procédé de dépôt physique en phase vapeur.

2. Procédé selon la revendication 1, dans lequel dans l'étape de nitruration la couche nitrurée est formée avec une épaisseur non inférieure à 40 $\mu$m.

3. Procédé selon l'une quelconque des revendications précédentes, dans lequel le matériau en acier comprend, en masse, 0,04 % à 0,15 % d'aluminium.

4. Procédé selon l'une quelconque des revendications précédentes, dans lequel le film de revêtement dur comprend des nitrures.

5. Procédé selon la revendication 4, dans lequel les nitrures comprennent de l'aluminium et du chrome.

**EP 3 006 601 B1**

**Patent documents cited in the description**

- JP 2009132990 A
- JP 2006193790 A
- JP 2008189982 A
- WO 2012115024 A
- JP 2012107265 A
- US 20030059632 A1
- JP 58031066 B
- WO 9950469 A